# EUROPEAN PATENT APPLICATION

(11) **EP 2 267 188 A1**
(43) Date of publication of application: **29.12.2010**
(21) Application number: 09735167.0
(22) Date of filing: 26.02.2009
(51) Int. Cl.: C30B 15/02, C30B 29/06

(54) **SINGLE-CRYSTAL GROWTH APPARATUS AND RAW-MATERIAL SUPPLY METHOD**

(30) Priority: 25.04.2008 JP 2008116240
(71) Applicant: SUMCO Corporation, Minato-ku Tokyo 105-8634 (JP)
(72) Inventor: FUJIWARA, Toshiyuki, Tokyo 105-8634 (JP); HOSOI, Takehiko, Tokyo 105-8634 (JP); YOTSUI, Takuya, Tokyo 105-8634 (JP); FURUYA, Hisashi, Tokyo 105-8634 (JP)
(74) Representative: Albrecht, Thomas
(86) International application number: PCT/JP2009/053509
(87) International publication number: WO 2009/130943

(57) **Abstract**

A single-crystal growth apparatus includes: a raw-material accumulation tube housed in a pull chamber; a bottom lid attached to a lower end opening of the raw-material accumulation tube; a shaft connected to the bottom lid to lift/lower the accumulation tube and bottom lid; a forward/backward movable raw-material guide tube having a leading end to be inserted through a side wall of the pull chamber into the raw-material accumulation tube; and a raw-material supply apparatus for supplying solid raw materials through the raw-material guide tube into the raw-material accumulation tube, in which the solid raw materials are supplied from the raw-material supply apparatus, through the raw-material guide tube, to the raw-material accumulation tube with the leading end of the raw-material guide tube being inserted into the raw-material accumulation tube, so as to accumulate the solid raw materials, and the bottom lid is lowered to drop the solid raw materials into a crucible. Thus a large amount of raw-material melt can be formed efficiently in the crucible during growth of single crystal.

## Description

### Field of the Invention:

The present invention relates to a single-crystal growth apparatus provided with a raw-material supply mechanism, which is used to form a large amount of raw-material melt in growth of silicon single crystal by the Czochralski method (hereinafter referred to as "CZ method"), and a raw-material supply method adopted in the apparatus. In particular, the present invention relates to a single-crystal growth apparatus and a raw-material supply method which are suitable in case of additional charging or recharging of solid raw materials to the raw-material melt in a crucible.

### Background Art:

The growth of silicon single crystal by the CZ method is generally carried out as described below. Solid raw materials of polycrystalline silicon charged in a crucible are heated and melted by a heater surrounding the crucible. When a raw-material melt is formed in the crucible, a seed crystal located above the crucible is lowered and dipped in the raw-material melt. From this state, the seed crystal is gradually pulled up while the seed crystal and crucible are rotated in a predetermined direction, whereby a silicon single crystal is grown below the seed crystal.

The grown single crystal includes: a diameter increasing part (called a crown part or shoulder part) having diameter successively increasing from a necking part, formed just below the seed crystal, to a desired diameter; a cylindrical part having the desired diameter, which is used as a product; and a diameter decreasing part (called an end cone part or tail part) having diameter successively decreasing from the cylindrical part for preventing the generation of dislocations during the final stage of the growth. Further, a small amount of melt which is uncrystallized is left in the crucible.

Since lump materials are mainly used as solid raw materials to be charged into the crucible at the initial charging, the filling ratio of solid raw materials in the crucible is limited due to existence of spaces among solid raw materials in the crucible. Therefore, the amount of raw-material melt after heating and melting does not come up to the allowable capacity of the crucible.

On the other hand, in growing single crystals, when diameters of cylindrical parts are always constant, it is possible to set dimensions and geometries of diameter increasing and decreasing parts, along with the amount of the residual melt in the crucible, to be constant, regardless of the length of the cylindrical part. Therefore, when a single crystal is grown from a large amount of raw-material melt, the weight ratio (yield) of cylindrical part to raw material in use can be improved to achieve high productivity, the cylindrical part being directed to a product.

Accordingly, to enhance the productivity of single crystal, the pulling of single crystal must be performed while ensuring that the amount of raw-material melt is as large as possible. Therefore, after solid raw materials that are charged in the crucible as the initial charging are melted, additional charging for additionally supplying further solid raw materials is performed.

As the method for single crystal growth, the so-called multi-pulling method is also known, the method including: after the growth of a single crystal, supplying solid raw materials into a crucible, in which the melt is left, to form the raw-material melt of substantially the same amount as the previous growth of the single crystal; and successively pulling a single crystal. The supply of solid raw materials in the multi-pulling method is called 'recharging'.

Both the additional charging and recharging are to supply raw materials to the melt in the crucible to increase the amount of raw-material melt in the crucible, and are performed by similar methods. As the methods of the supply of raw materials in the additional charging or recharging, there are a cut rod method, a chunk tube method, a raw-material feeder method, and a melt supply method.

In the cut rod method, a columnar solid raw material called a cut rod is suspended above a crucible, and lowered to be dipped in the melt in the crucible and gradually melted from its lower end, whereby the amount of raw-material melt is increased (refer to, for example, Japanese Patent No. 3572998).

In the chunk tube method, a cylindrical quartz tube, called a chunk tube, which is filled with lump solid raw materials, is located above a crucible, and lowered to just above the melt surface in the crucible. Thereafter, a bottom lid attached to a lower end opening of the quartz tube is displaced downward to open the lower end opening of the quartz tube, whereby raw materials are supplied to be melted to increase the amount of raw-material melt (refer to, for example, WO2002/068732).

In the raw-material feeder method, lump or granular solid raw materials are delivered from a tank which stores the solid raw materials, and then put into a quartz-made feed tube from the upper part thereof, thus enabling, through the tube, the raw materials to be loaded onto a melt in a crucible from the lower end of the tube to thereby increase the amount of raw material melt (refer to, for example, Japanese Patent No. 2935337, and Japanese Patent Application Publication Nos. 2003-2779 and 2006-21973).

In the melt supply method, solid raw materials are melted in a container which is different from a crucible for use in pulling a single crystal, and the melted raw material is supplied to the melt in the crucible to increase the amount of raw-material melt (refer to, for example, Japanese Patent Application Publication No. 2000-264774).

### Disclosure of the Invention:

In recent years, it has been attempted to further increase the diameter of single crystal (the diameter of the cylindrical part), and in association with this, the capacity of the crucible is also increased. Therefore, a method capable of forming a larger amount of raw material melt in the crucible is strongly demanded. However, each of the above-mentioned raw-material supply methods has the following problems.

In case of the cut rod method, since the cut rod, that is a solid raw material, has a limit to its producible weight, the increase in amount of raw-material melt by one cut rod is limited. Further, the cut-rod may fracture and fall, while it is melted. Therefore, successive supply of lightweight cut rods is practically carried out to avoid the fracture. In this case, however, the replacement of cut rods or the heating for melting the cut rod requires a considerable amount of labor and time, resulting in the decrease in production efficiency.

In case of the chunk tube method, the amount of solid raw materials is limited by that to be accommodated in the quartz tube, so that when the supply of solid raw materials beyond it is needed, an emptied quartz tube must be successively exchanged for another quartz tube filled with solid raw materials. Therefore, exchanging quartz tubes requires a considerable amount of labor and time, and improvement in production efficiency cannot be expected.

In case of the raw-material feeder method, solid raw materials move downward through the feed tube and are dropped into a melt, and when it reaches the melt, splashes of liquid take place. The splash triggers to generate dislocations in a single crystal. To prevent the occurrence of splashes of liquid, a special mechanism for reducing the dropping velocity of solid raw materials is needed. Further, since solid raw materials are dropped at a limited area on the melt surface in the crucible and therefore likely to be locally deposited and stacked, the amount of solid raw materials which can be supplied to the crucible at a time is limited. Therefore, it takes a long time to supply a large amount of solid raw materials.

In case of the melt supply method, a complicate heating mechanism is needed to prevent the melted raw material from being solidified while it is guided to the crucible. Further, since there is a limit to the rate of melting solid raw materials for forming a melted raw material, it is difficult to supply a large amount of the melted raw material in a short time.

Since it thus takes a long time to obtain a large amount of raw material melt by additional charging or recharging according to either of the conventional methods for supplying raw materials, there are problems in the production efficiency when they are applied to cope with the increase in diameter of single crystal, which requires a larger amount of raw material melt.

In view of the above-mentioned problems, the present invention is made, and has an object to provide a single-crystal growth apparatus provided with a raw-material supply mechanism, capable of efficiently forming a large amount of raw-material melt in a crucible during additional charging or recharging in single crystal growth by the CZ method, and a raw-material supply method adopted in the apparatus.

To attain the above-mentioned object, a single-crystal growth apparatus according to the present invention is the one which is used for growth of single crystal by the CZ method, and is provided with a raw-material supply mechanism for additionally charging or recharging granular/lump solid raw materials to a raw-material melt in a crucible, including: a main chamber having said crucible located therein; a pull chamber connected to an upper end portion of the main chamber, and housing a grown single crystal therein; a raw-material accumulation tube housed in the pull chamber in such a manner as allowing it to be lifted or lowered; a bottom lid detachably attached to a lower end opening of the raw-material accumulation tube; a lifting/lowering device which runs through the inside of said raw-material accumulation tube to be connected to said bottom lid and allows said raw-material accumulation tube and bottom lid to be lifted or lowered; a forward/backward movable raw-material guide tube having its leading end, running through a side wall of said pull chamber, inserted into said raw-material accumulation tube; and a raw-material supply apparatus for delivering said solid raw materials through the raw-material guide tube into said raw-material accumulation tube.

According to such a structure, while the leading end of said raw-material guide tube has been inserted in said raw-material accumulation tube, said solid raw materials can be delivered from said raw-material supply apparatus, through said raw-material guide tube, to said raw-material accumulation tube, to which said bottom lid is attached, for accumulating said solid raw materials, and then, the lower end opening of said raw-material accumulation tube is opened by lowering said bottom lid so as to drop said solid raw-materials inside said raw-material accumulation tube into said crucible. Therefore, while the raw-material accumulation tube is held above the crucible, the accumulation of solid raw materials into the raw-material accumulation tube and the dropping of solid raw materials from the raw-material accumulation tube are repeatedly performed so as to continuously supply the solid raw materials to the crucible.

With respect to this single-crystal growth apparatus, in view of preventing failures of the raw-material accumulation tube and/or the bottom lid, the failures being attributed to the solid raw materials supplied from the raw-material guide tube to the raw-material accumulation tube, a buffer plate with which the solid raw materials inputted from the leading end of the raw-material guide tube collide is preferably provided inside the raw-material accumulation tube.

Further to attain the above-mentioned object, a raw-material supply method according to the present invention is the one for additionally charging or recharging granular/lump solid raw materials to a raw-material melt in a crucible during growth of single crystal by the CZ method, comprising: connecting a pull chamber to an upper end portion of a main chamber having said crucible located therein, and locating a raw-material accumulation tube, with a detachable bottom lid attached to a lower end opening thereof, in the pull chamber; moving a raw-material guide tube forward so that the raw-material guide tube runs through a side wall of the pull chamber and enters into the raw-material accumulation tube; delivering the solid raw materials from a raw-material supply apparatus, through the raw-material guide tube, into the raw-material accumulation tube for accumulating the solid raw materials; and releasing the bottom lid attached to the lower end opening of the raw-material accumulation tube to drop the solid raw materials inside the raw-material accumulation tube into the crucible.

Also according to such a raw-material supply method, a large amount of solid raw materials can be continuously and successively supplied into the crucible, as the above-mentioned single-crystal growth apparatus.

In this raw-material supply method, it is preferred to repeat the accumulation of the solid raw materials into the raw-material accumulation tube and the dropping of the solid materials inside the raw-material accumulation tube.

According to the single-crystal growth apparatus and the raw-material supply method of the present invention, a large amount of solid raw materials can be continuously and successively supplied into the crucible during additional charging or recharging operation in growth of single crystal by the CZ method, and as a result, a large amount of raw-material melt can be formed efficiently in the crucible. Consequently, growth of the single crystal with an increased diameter that requires a larger amount of raw-material melt can be realized.

### Brief Description of the Drawings:

Fig. 1 is a vertical sectional view showing the overall configuration of a single-crystal growth apparatus provided with a raw-material supply mechanism according to the present invention;
Figs. 2 are enlarged views showing the lower part of a raw-material accumulation tube constituting the raw-material supply mechanism, whereas (a) is a vertical sectional view, and whereas (b) is a cross sectional view;
Fig. 3 is an external perspective view of a metallic band which is used to secure a metallic flange for limiting the lowering of the raw-material accumulation tube;
Figs. 4 are views for illustrating the process of additional charging in the single-crystal growth apparatus of the present invention; and
Fig. 5 is a top view which schematically shows a configuration example of the single-crystal growth apparatus, capable of enhancing the efficiency of a series of operations in growth of single crystal.

### Best Mode for Carrying Out the Invention:

Hereinafter, preferred embodiments of the single-crystal growth apparatus and the raw-material supply method according to the present invention will be described in detail in reference to the accompanying drawings.

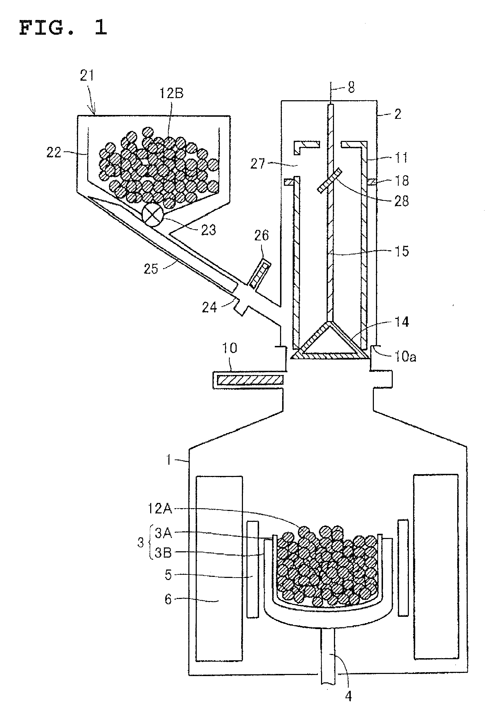

Fig. 1 is a vertical sectional view showing the overall configuration of a single-crystal growth apparatus provided with a raw-material supply mechanism according to the present invention. In the same figure, it is shown that solid raw materials of initial charge are filled in a crucible, and preparation of additional charging is also completed.

The single-crystal growth apparatus by the CZ method includes, as shown in the same figure, a framework composed of a main chamber 1 and a pull chamber 2, and a gate valve 10. The pull chamber 2 is cylindrical, smaller in diameter than the main chamber 1, and is connected to an upper end portion of the main chamber 1 coaxially with the main chamber 1 via the gate valve 10.

The gate valve 10 is provided to allow the inside of the main chamber 1 to provide or shut communication with the inside of the pull chamber 2. An upper opening of the gate valve 10 as being arranged on the upper end portion of the main chamber 1 is smaller in diameter than the pull chamber 2.

A crucible 3 is located in the central area inside the main chamber 1. The crucible 3 has a double structure composed of an inner quartz crucible 3A and an outer graphite crucible 3B, and is supported on a support shaft 4 by means of a crucible susceptor called a pedestal not shown. The support shaft 4 is driven so as to circumferentially rotate the crucible 3 and to axially lift or lower the crucible 3.

A resistance-heating heater 5 is located outside the crucible 3 in such a manner as surrounding the crucible 3. On the outside of the heater 5, a heat insulating material 6 is located along the inner circumferential surface of the main chamber 1. Solid raw materials 12A charged in the crucible 3 as initial charge are melted by heating with the heater to form raw-material melt. Solid raw materials 12B supplied into the crucible 3 by additional charging or recharging which will be described later are also melted by heating with the heater 5 to form raw-material melt.

After the initially charged solid raw materials 12A are melted, additional charging is performed to ensure a large amount of raw-material melt by increasing the amount of the raw-material melt in the crucible 3. A raw-material supply mechanism which is used during the additional charging is constituted as described below.

In the pull chamber 2, a pull-up shaft 8 such as a wire is provided in a suspended manner, and a cylindrical raw-material accumulation tube 11 is located above the crucible 3, by means of a suspension tool not shown, which is connected to the lower end of the pull-up shaft 8, and by means of a metallic shaft 15 as a lifting shaft. The pull-up shaft 8 is driven to rotate, and also driven to lift or lower by a drive unit not shown, which is installed on a top part of the pull chamber 2. The raw-material accumulation tube 11 is lifted or lowered according to the lifting or lowering movement of the pull-up shaft 8.

A conical bottom lid 14 is detachably attached to a lower end opening of the raw-material accumulation tube 11 to accumulate solid raw materials in the tube 11 during the additional charging. The metallic shaft 15 vertically extending through the inside of the raw-material accumulation tube 11 from above is connected to the bottom lid 14. The raw-material tube 11 and the bottom lid 14 which are exposed to the solid raw materials are preferably made of quartz, SiC, a carbon material with its surface being coated with SiC, or a metal subjected to special surface treatment so as to prevent contamination of impurities to the solid raw materials, and in particular, quartz is desirable.

A raw-material supply apparatus 21 is arranged outside the pull chamber 2. The raw-material supply apparatus 21 includes a tank 22 which stores granular/lump solid raw materials 12B, and is configured to deliver the solid raw materials 12B from the bottom of the tank 22 by opening a valve 23 provided at the bottom of the tank 22.

An inclined tube 24 inclined downwards at a predetermined angle is extended from a lower part of the raw-material supply apparatus 21, with the lower end of the inclined tube 24 being connected to the side wall of the lower part of the pull chamber 2. A raw-material guide tube 25 made of quartz or SiC is housed in the inclined tube 24. The raw-material guide tube 25 is configured to be movable forward/backward inside the inclined tube 24, being driven by a motor or hydraulics cylinder. The forward movement of the raw-material guide tube 25 makes its leading end to pass through the side wall of the pull chamber 2 and enter the inside of the pull chamber 2. An inclined tube shutter 26 is provided in the vicinity of the lower end of the inclined tube 24 to allow the inside of the inclined tube 24 to be isolated or to be communicated.

An annular metallic flange 18 is provided on the outer circumferential surface of the upper part of the raw-material accumulation tube 11. When the raw-material accumulation tube 11 is lowering, the metallic flange 18 functions as a stopper by touching with the end surface 10a of an upper minor-diameter segment above the gate valve 10, to thereby limit the further lowering and makes the raw-material accumulation tube 11 to stop at that position.

Further, a penetration port 27 is provided on the circumferential surface of the upper part of the raw-material accumulation tube 11, being located above the metallic flange 18 as well as on the same side as where the inclined tube 24 extended from the raw-material supply apparatus 21 is arranged. Since the penetration port 27 is provided to be located on an extended line of the inclined tube 24 when the lowering of the raw-material accumulation tube 11 is stopped by the metallic flange 18, thereby allowing the leading end of the raw-material guide tube 25 to pass through the penetration port 27 by moving forward inside the inclined tube 24.

A buffer plate 28 made of quartz or polycrystalline silicon is provided inside the raw-material accumulation tube 11 so as to be located on an extended line of the inclined tube 24 when the lowering of the raw-material accumulation tube 11 is stopped by the metallic flange 18. The buffer plate 28 is fixed to the inner circumferential surface of the raw-material accumulation tube 11 so as to be perpendicular to the axis of the inclined tube 24 or face slightly more upward therefrom.

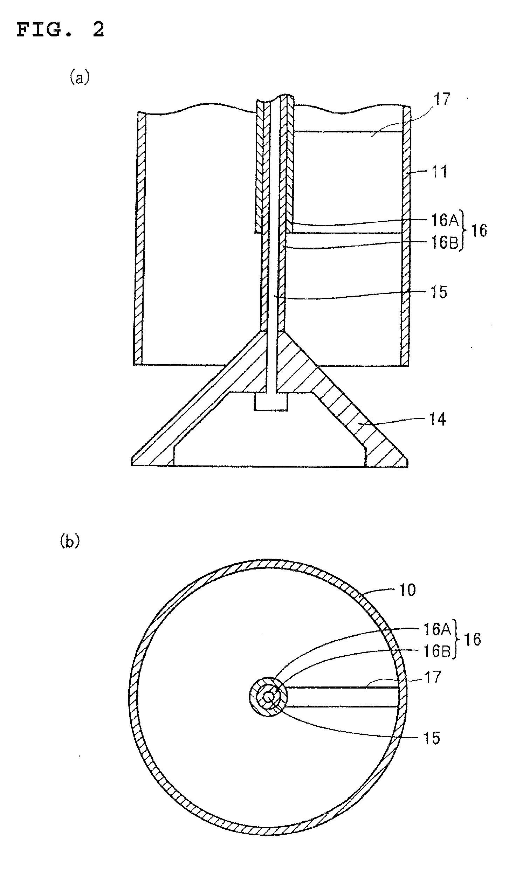

Figs. 2 are enlarged views showing the lower part of the raw-material accumulation tube constituting the raw-material supply mechanism, whereas (a) is a vertical sectional view, and whereas (b) is a cross sectional view.

As shown in the same figures, the metallic shaft 15 is covered with a protector tube assembly 16. The protector tube assembly 16 is composed of an external primary protector tube 16A and a sub-protector tube 16B slidably inserted into the inside of the primary protector tube 16A, and the metallic shaft 15 is retained by the sub-protector tube 16B. Since the primary protector tube 16A and the sub-protector tube 16B are exposed to the solid raw materials, they are desirably made of quartz, similarly to the raw-material accumulation tube 11 and the bottom lid 14. The primary protector tube 16A is extended vertically on the central axis of the raw-material accumulation tube 11, and fixed to the inner circumferential surface of the raw-material accumulation tube 11 by means of a support plate 17.

Therefore, since the metallic shaft 15 is covered with the protector tube 16 to inhibit contacting with the solid raw material, contamination into the solid raw materials can be surely prevented. Further, since the sub-protector tube 16B retaining the metallic shaft 15 is guided by the sliding of the sub-protector tube 16B in the primary protector tube 16A, the metallic shaft 15 can perform stable lifting or lowering operation without being offset from the central position of the raw-material accumulation tube 11.

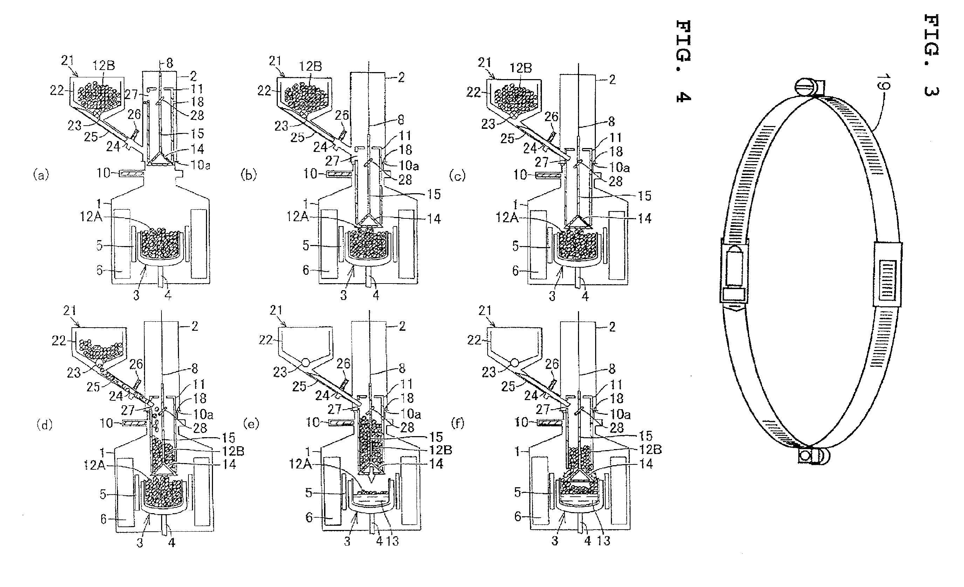

Fig. 3 is an external perspective view of a metallic band used to secure the metallic flange for limiting the lowering of the raw-material accumulation tube. The metallic flange 18 shown in Fig. 1 is retained by fastening metallic bands 19, the one being shown in Fig. 3, to the outer circumferential surface of the raw-material accumulation tube 11 at positions sandwiching the flange from above and below. The lowering stop position of the raw-material accumulation tube 11 can be adjusted by adjusting the fastening height of the metallic bands 19.

Hereinafter, the process of additional charging using the single-crystal growth apparatus thus configured will be described step by step.

Figs. 4 are illustrative views of the process of additional charging in the single-crystal growth apparatus according to the present invention. As shown in Fig. 4(a), the raw-material tube 11 which is empty is suspended inside the pull chamber 2 through a suspension tool connected to the lower end of the pull-up shaft 8 and the metallic shaft 15, and this pull chamber 2 is connected to an upper end portion of the main chamber 1 in which solid raw materials 12A of initial charge are filled in the crucible 3.

On the other hand, solid raw materials 12B are inputted into the tank 22 of the raw-material supply apparatus 21, and the solid raw materials 12B are stored in the tank 22. At this time the solid raw materials 12B with relatively small particle size are stored at the bottom side of the tank 22. For example, the particle size of solid raw materials 12B at the bottom side of the tank 22 is 10 to 30 mm, and the particle size of solid raw materials 12B stored at a site other than the bottom side is 30 to 50 mm.

Then, heating of the solid raw materials 12A filled in the crucible 3 is started by electrifying the heater 5. And the gate valve 10 is opened, and the inclined tube shutter 26 is also opened.

Then, the pull-up shaft 8 is lowered as shown in Fig. 4(b) to lower the raw-material accumulation tube 11 until the metallic flange 18 touches the end surface of the upper minor-diameter portion 10a of the gate valve 10. At this point of time, the lowering of the pull-up shaft 8 is intervened once. Namely, at this point of time, the raw-material accumulation tube 11 is being held just above the crucible 3 with the lower end opening being closed by the bottom lid 14.

The raw-material guide tube 25 is then moved forward along the inside of the inclined tube 24 as shown in Fig. 4(c). And by this, the leading end of the raw-material guide tube 25 passes through the side wall of the pull chamber 2 and the penetration port 27 of the raw-material accumulation tube 11 to enter the inside of the raw-material accumulation tube 11, while the opposite end of the raw-material guide tube 25 is located just below the valve 23 of the raw-material supply apparatus 21.

The valve 23 of the raw-material supply apparatus 21 is then opened, as shown in Fig. 4(d), to deliver a predetermined amount of solid raw materials 12B. At this time, the solid raw materials 12B with small particle size accumulated at the bottom side of the tank 22 are initially taken out, and then the solid raw materials 12B with relatively large particle size are taken out. The delivered solid raw materials 12B are introduced into the raw-material guide tube 25, traveling the inside of the raw-material guide tube 25, and inputted to the raw-material accumulation tube 11 from the leading end of the tube 25. The input solid raw materials 12B collide with the buffer plate 28 and drop, and are deposited and accumulated inside the raw-material accumulation tube 11.

At that time, since the solid raw materials 12B input from the raw-material guide tube 25 are decelerated due to absorption of kinetic energy by the collision with the buffer plate 28, the subsequent dropping velocity is moderated. Accordingly, even if the solid raw materials 12B collide with the inner circumferential surface of the raw-material accumulation tube 11 or the upper slant side surface of the bottom lid 14, incurred damages on the raw-material accumulation tube 11 and/or the bottom lid 14 are small. Thus, failures of the raw-material accumulation tube 11 or the bottom lid 14 can be prevented.

Further, since the solid raw materials 12B with small particle size which inherently incur less damages on the raw-material accumulation tube 11 or the bottom lid 14 are initially inputted and firstly deposited on the bottom lid 14, the solid raw materials 12B with small particle size play the role of a cushion against subsequently falling solid raw materials 12B with large particle size. Therefore, the inputting procedure combined with the reduction in dropping velocity of the solid raw materials 12B by the buffer plate 28 can prevent failures of the raw-material accumulation tube 11 or bottom lid 14.

Then, when the melting of the solid raw materials 12A in the crucible 3 is substantially or completely terminated, as shown in Fig. 4(e), the pull-up shaft 8 is further lowered to lower the bottom lid 14.

Thus, the lower end opening of the raw-material accumulation tube 11 is released, as shown in Fig. 4(f), and the solid raw materials 12B in the raw-material accumulation tube 11 drop by own weight and supplied to the raw-material melt 13 in the crucible 3. At that time, the solid raw materials 12B in the raw-material accumulation tube 11 are input circumferentially-uniformly along the upper slant side surface of the conical bottom lid 14, and therefore the solid raw materials 12B are in a widely distributed manner deposited over the raw-material melt 13 in the crucible 3 without generating splashes of liquid. Consequently, a large amount of solid raw materials 12B can be supplied into the crucible 3 at one time.

When the raw-material accumulation tube 11 is emptied, the pull-up shaft 8 is lifted to close the lower end opening of the raw-material accumulation tube 11 by the bottom lid 14. The steps of Figs. 4(c) to (f) are repeated until the amount of the raw-material melt in the crucible 3 reaches a target value which allows growth of single crystal with high productivity.

Thus, according to the present invention, while the raw-material accumulation tube is held just above the crucible that is the lowering limit position, the accumulation of solid raw material in the raw-material accumulation tube by the delivery of solid raw material from the raw-material supply apparatus and the dropping of the solid raw materials, which has been accumulated in the raw-material accumulation tube, into the crucible are repeated so as to continuously supply the solid raw materials to the crucible, and as a result, a large amount of raw-material melt can be formed in the crucible.

Namely, according to the present invention, since the replacement of cut rods in the conventional cut rod method or the exchange of quartz tubes in the chunk tube method is not necessary at all, a large amount of raw-material melt can be formed efficiently in a short time. Further, since a large amount of solid raw materials can be supplied from the raw-material accumulation tube to the crucible at one time according to the present invention, formation of a large amount of raw-material melt can be performed in a short time, compared with the case of the conventional raw material feeder method or melt supply method. Consequently, the present invention exhibits a further distinctive effect when applied to the growth of single crystal of increased diameter which requires a larger amount of raw-material melt.

Further, in case of the conventional raw material feeder method, when the solid raw materials are delivered, the delivery rate is often controlled. Thus, for controlling delivered weight, a special device such as a vibrating feeder or a weight measuring load cell is installed in a feeder. However, according to the present invention, since the installation of such a device is not necessary, the structure can be simplified.

When the amount of the raw-material melt in the crucible reaches the target value, the pull-up shaft is raised to house the raw-material accumulation tube in the pull chamber, and the gate valve and the inclined tube shutter are closed, although not shown in the drawings. Thereafter, the pull chamber is removed from the main chamber. The raw-material accumulation tube and the metallic shaft inside the pull chamber are replaced by a seed crystal, and this pull chamber is connected to the main chamber. Alternately, a separately prepared pull chamber with a seed crystal may be connected to the main chamber.

The seed crystal is dipped into the raw-material melt in the crucible, and the seed crystal is pulled up to grow a silicon single crystal.

Although the explanation about the supply of raw materials in case of additional charging is described above, the supply of raw materials in case of recharging is also performed according to the same process. Namely, after growing and pulling up the single crystal, solid raw materials are supplied to the melt left in the crucible according to the steps shown in Figs.4(a) to (f).

The present invention is not limited to the above-mentioned embodiments, and can be variously modified without departing from the spirit and scope of the present invention. For example, for supplying the raw materials by additional charging or recharging, the solid raw materials may be preliminarily charged into the raw-material accumulation tube housed in the pull chamber when connected to the main chamber. In this case, firstly the raw-material accumulation tube is lowered to the lowering limit position, and then the bottom lid is lowered to drop the solid raw materials as being charged in the raw-material accumulation tube, into the crucible, secondly the bottom lid is lifted to close the lower end opening of the raw-material accumulation tube, and then the step shown in Fig. 4(c) is to be operated.

In the above-mentioned embodiment, although the metallic flange for limiting the lowering of the raw-material accumulation tube is secured by the metallic bands, a plurality of projections may be arranged circumferentially on the outer circumferential surface of the raw-material accumulation tube so that the metallic flange is secured by the projections. As the lifting shaft which controls the lifting and lowering of the raw-material accumulation tube, a metallic wire can be used instead of the metallic shaft.

For further enhancing the efficiency of a series of the operations for growing a single crystal, which include the raw material supply by additional charging or recharging, the following structure can be adopted.

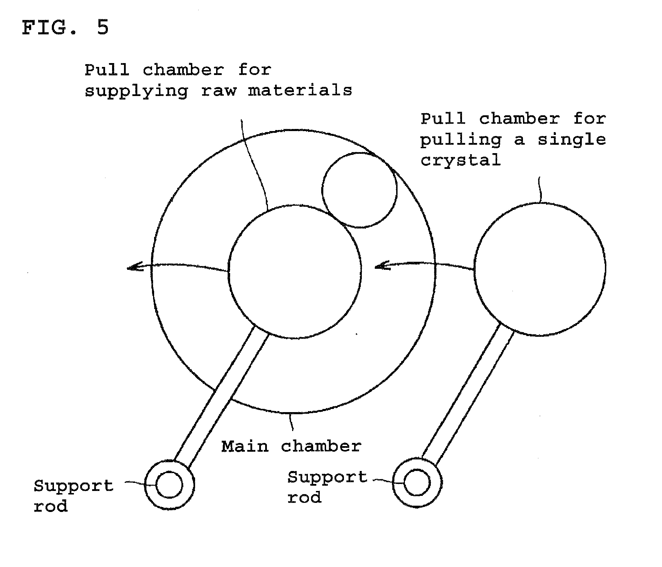

Fig. 5 is a top view schematically showing a configuration example of the single-crystal growth apparatus, capable of enhancing the efficiency of a series of operations in single crystal growth. The single-crystal growth apparatus shown in the same figure includes double pull chambers for a single main chamber containing a crucible therein. The one is for supplying raw materials, which constitutes the above-mentioned raw-material supply mechanism of the present invention, and the other pull chamber is for pulling a single crystal, which is provided with a seed crystal. The pull chamber for supplying raw materials and the other for pulling a single crystal are horizontally rotatably supported by vertical support rods located adjacent to the main chamber by means of arms, respectively. Each pull chamber can be arranged at the assembling position above the main chamber or at a discrete position therefrom by swinging around its support rod.

According to such a structure, as shown in Fig. 5, after the pull chamber for supplying raw materials is connected to the main chamber, and the raw material supply by additional charging or recharging is completed, the pull chamber for supplying raw materials is rotated to be removed from the position above the main chamber, and then the pull chamber for pulling a single crystal is brought in a rotated manner to the position above the main chamber, and connected to the main chamber to pull a single crystal. Namely, after the raw material supply by additional charging or recharging, the pulling of single crystal can be started without spending unnecessary time.

Further, after the pull chamber for pulling a single crystal is connected to the main chamber, and the pulling of single crystal is completed, the pull chamber for pulling the single crystal is rotated to be removed from the position above the main chamber, and then the pull chamber for supplying raw materials is rotated to the position above the main chamber, and connected to the main chamber to supply solid raw materials.

Namely, also after the pulling of single crystal, the raw material supply by additional charging or recharging can be started without spending unnecessary time. Time during supplying raw materials by use of the pull chamber for supplying raw materials can be effectively used to cool a single crystal inside the pull chamber for pulling the single crystal.

Therefore, providing one pull chamber for supplying raw materials and the other for pulling a single crystal independently for a single main chamber allows the efficiency of a series of operations in single crystal growth to be enhanced.

### Industrial Applicability

According to the single-crystal growth apparatus and raw-material supply method of the present invention, a large amount of raw-material melt can be efficiently formed in a crucible during additional charging or recharging in single crystal growth by the CZ method. Thus, the present invention is extremely useful for the growth of single crystal of increased diameter which requires a larger amount of raw-material melt.

## Claims

1. A single-crystal growth apparatus which is used for growth of single crystal by the Czochralski method, and is provided with a raw-material supply mechanism for additionally charging or recharging granular and/or lump solid raw materials to a raw-material melt in a crucible, **characterized in that**:
a main chamber having the crucible located therein;
a pull chamber connected to an upper end portion of the main chamber, and housing a grown single crystal therein;
a raw-material accumulation tube which is housed in the pull chamber, being allowed to be lifted or lowered;
a bottom lid detachably attached to a lower end opening of the raw-material accumulation tube;
a lifting/lowering device which runs through the inside of the raw-material accumulation tube to be connected to the bottom lid, and allows lifting/lowering the raw-material accumulation tube and bottom lid;
a forward/backward movable raw-material guide tube having a leading end to be inserted through a side wall of the pull chamber into the raw-material accumulation tube; and
a raw-material supply apparatus for supplying the solid raw materials through the raw-material guide tube into the raw-material accumulation tube.

2. The single-crystal growth apparatus according to claim 1, **characterized in that** a buffer plate with which the solid raw materials inputted from the leading end of the raw-material guide tube collide is provided inside the raw-material accumulation tube.

3. A raw material supply method for additionally charging or recharging granular and/or lump solid raw materials to a raw-material melt in a crucible during growth of single crystal by the Czochralski method, **characterized in that**:
connecting a pull chamber to an upper end portion of a main chamber having the crucible located therein, and locating a raw-material accumulation tube, with a detachable bottom lid attached to a lower end opening thereof, in the pull chamber;
moving a raw-material guide tube forward so that the raw-material guide tube passes through a side wall of the pull chamber and enters into the raw-material accumulation tube;
inputting the solid raw materials from a raw-material supply apparatus, through the raw-material guide tube, into the raw-material accumulation tube to accumulate the solid raw materials; and
opening the bottom lid attached to the lower end opening of the raw-material accumulation tube to drop the solid raw materials, in the raw-material accumulation tube, into the crucible.

4. The raw material supply method according to claim 3, **characterized in that** the accumulation of the solid raw materials into the raw-material accumulation tube and the dropping of the solid raw material in the raw-material accumulation tube are repeated.
